# EUROPÄISCHE PATENTSCHRIFT

(11) **EP 2 097 980 B1**
(45) Veröffentlichungstag und Bekanntmachung des Hinweises auf die Patenterteilung: **08.01.2014**
(21) Anmeldenummer: 07822531.5
(22) Anmeldetag: 13.11.2007
(51) Int. Cl.: H03K 19/003

(54) **INTEGRIERTE SCHALTUNG MIT STRAHLUNGSSCHUTZ**
RADIATION-PROTECTED INTEGRATED CIRCUIT
CIRCUIT INTÉGRÉ PROTÉGÉ CONTRE LES RAYONNEMENTS

(30) Priorität: 23.11.2006 DE 102006055867
(43) Veröffentlichungstag der Anmeldung: 09.09.2009
(73) Patentinhaber: IHP GmbH-Innovations for High Performance Microelectronics / Leibniz-Institut für innovative Mikroelektronik, 15236 Frankfurt / Oder (DE)
(72) Erfinder: SCHOOF, Gunter, 15236 Frankfurt (Oder) (DE); KRAEMER, Rolf, 15517 Fürstenwalde (DE)
(74) Vertreter: Eisenführ Speiser
(86) Internationale Anmeldenummer: PCT/EP2007/062257
(87) Internationale Veröffentlichungsnummer: WO 2008/061915

(56) Entgegenhaltungen:
- WO-A-2005/119777
- US-A- 5 596 286
- US-A- 5 689 632

## Beschreibung

Die Erfindung betrifft eine integrierte Schaltung mit Schutz gegen energiereiche Strahlung und ein korrespondierendes Verfahren zum Erzeugen einer solchen Schaltung.

Bei integrierten Schaltungen sind sogenannte Single-Event-Effekte (SEE) bekannt, welche durch energiereiche Strahlung, wie z.B. Protonen oder schwere Ionen, ausgelöst werden. Eine derartige Strahlung tritt unter anderem im Weltraum, in Kernreaktoren oder Teilchenbeschleunigern auf. Bei den Single-Event-Effekten kann es insbesondere zum ungewünschten Umschalten eines gespeicherten Bitzustandes kommen, was als Single-Event-Upset (SEU) bekannt ist. Darüber hinaus sind die Single-Event-Latchups (SEL) bekannt, welche sich in einem Kurzschluss der Betriebsspannung des Chips äußern. Der Latchup-Effekt besteht üblicherweise darin, dass eine PNPN-Struktur, welche als gestapelte PNP- und NPN-Transistoren wirken, eine leitende Verbindung aufbaut, welche die Spannungsversorgung über die elektronischen Bauteile kurzschließt. Infolge eines Latchup-Effekts werden die beteiligten Komponenten zerstört, wenn nicht rechtzeitig die Spannungsversorgung abgeschaltet wird. Die parasitäre Thyristorstruktur tritt als Teil eines PMOS- und NMOS-Transistorpaares auf. SEUs treten im Vergleich zu SELs wesentlich häufiger auf. SEEs weisen im Bezug auf die Taktfrequenz integrierter Schaltungen eine deutlich höhere Zeitkonstante auf und werden daher zeitlich als einzelne und nicht etwa als gleichzeitig mehrfach auftretende Ereignisse betrachtet. Sogenannte Multiple-Bit-Upsets (MBUs) können jedoch durch Summierung, z.B. in einem Byte eines Speichers, über längere Zeiträume auftreten und sind dann unter Umständen nicht mehr korrigierbar oder nicht mehr erkennbar.

Um die vorgenannten Fehler bzw. auf den genannten Effekten basierenden Fehlfunktionen zu verhindern, werden bei herkömmlichen Schaltungen bestimmte, redundante Schaltungsdesigns bevorzugt eingesetzt. Ein typischer Vertreter ist das Triple-Module-Redundancy (TMR) -Design. Gegen die seltener auftretenden Ereignisse, wie die SELs, werden spezielle Maßnahmen im Layout, wie z.B. Schutzringe, eine spezielle Transistorform oder Ähnliches eingesetzt. Eine nachträgliche Korrektur dieser Fehler auf Chipebene ist nicht bekannt und wird in Fachkreisen als zu aufwendig angesehen. Obwohl die bekannten Maßnahmen durchaus effektiv sind, kann ein sicherer SEL-Schutz damit nicht garantiert werden. Andere bekannte Konzepte zur Vermeidung von SELs bestehen darin, externe Überwachungsschaltungen vorzusehen, welche die Stromaufnahme der zu schützenden integrierten Schaltung dauerhaft überwachen und die Schaltung beim Überschreiten vorgegebener maximaler Werte für die Stromaufnahme von der Spannungsversorgung trennen. Nachteilig an diesen bekannten Konzepten sind die lange Zeitdauer, die erforderlich ist, um den ursprünglichen Systemzustand wieder herzustellen und ein eventueller Informationsverlust beim Abschalten.

Eine Schaltkreisvorrichtung mit den Merkmalen des Oberbegriffs des Anspruchs 1 und ein Entwurfsverfahren mit den Merkmalen des Oberbegriffs des Anspruchs 13 sind bekannt aus WO 2005/119 777 A.

Es ist eine Aufgabe der vorliegenden Erfindung, eine Schaltung bereitzustellen, welche Single-Event-Effekte besser handhaben kann als herkömmliche Schaltungen.

Gemäß der vorliegenden Erfindung wird die Aufgabe durch einen elektrischen Schaltkreis gemäß Anspruch 1 gelöst. Es sind erste Schaltmittel vorgesehen, um in Reaktion auf das Auftreten eines Single-Event-Effekts in dem ersten Schaltkreisabschnitt, die Stromaufnahme des ersten Schaltkreisabschnittes, zu begrenzen. Gemäß der vorliegenden Erfindung weist der erfindungsgemäße Schaltkreis mindestens einen Schaltkreisabschnitt auf. Ein derartiger Schaltkreisabschnitt kann z.B. aus einer Standardzelle aus einem oder mehreren digitalen Gattern, Registern, Speicherelementen oder beliebigen anderen elektronischen Komponenten, die zu einer Schaltung zusammengefügt sind, bestehen. Ein Schaltkreisabschnitt im Sinne dieser Anmeldung umfasst den Schaltungsteil, der von mindestens einem Schaltmittel (also Schalter oder einem Set von Schaltern) abgeschaltet werden kann. Erfindungsgemäß ist ein erstes Schaltmittel, wie z.B. ein Schalter aus einem Transistor, vorgesehen, welcher die Stromaufnahme des ersten Schaltkreisabschnittes begrenzt, wenn ein Single-Event-Effekt in dem entsprechenden ersten Schaltkreisabschnitt auftritt. Hierdurch wird insbesondere solchen Single Event-Effekten Rechnung getragen, welche sich in einer Erhöhung der Leistungs- bzw. Stromaufnahme des ersten Schaltkreisabschnitts auswirken. Die Stromaufnahme des Schaltkreisabschnittes kann insoweit entweder auf einen Maximalwert begrenzt werden, falls die Schaltung durch Auftreten der Störung einen Strom aufnimmt, welcher zur Zerstörung der Schaltung oder zu Fehlfunktionen führen kann. Ebenso kann der Strom dadurch begrenzt Werden, dass die Strompfade komplett unterbrochen, werden und kein Strom mehr fließt. Erfindungsgemäß wird das erste Schaltmittel derart mit dem ersten Schaltkreisabschnitt gekoppelt, dass nur der erste Schaltkreisabschnitt von der Spannungsversorgung getrennt wird, bzw. nur die Stromaufnahme des ersten Schaltkreisabschnittes begrenzt wird. Die übrigen Teile des erfindungsgemäßen Schaltkreises können dadurch ihre bestimmungsgemäßen Funktionen ungehindert weiter ausführen.

Gemäß einem weiteren vorteilhaften Aspekt der Erfindung weist der elektrische Schaltkreis ein dem ersten Schaltkreisabschnitt zugeordnetes Detektionsmittel auf, das zum Detektieren eines Ereignisses, z.B. eines hohen Stromes, vorgesehen ist, der auf einem Single-Event-Effekt beruht. Hierdurch wird einer der vorgenannten, vorteilhaften Aspekte der Erfindung fortgebildet, indem ein Detektionsmittel (z.B. irgendeine Sensorik mittels Shunt-Widerständen oder Ähnlichem) dem zu überwachenden ersten Schaltkreisabschnitt zugeordnet wird. Eine derartige vorteilhafte Ausgestaltung ermöglicht die individuelle Überwachung und das individuelle Strombegrenzen bzw. -abschalten des ersten Schaltkreisabschnittes, ohne dass der verbleibende Teil des erfindungsgemäßen Schaltkreises davon betroffen ist. Ein Schaltkreisabschnitt kann ein System beinhalten, welches bestimmte Funktionen erfüllt. So kann ein System spezifische logische Gatter, Latches, Flip-Flops, Speicher etc. beinhalten.

Gemäß der vorliegenden Erfindung umfasst der erfindungsgemäße Schaltkreis auch noch einen zweiten Schaltkreisabschnitt mit diesem zugeordneten zweiten Schaltmitteln, welche ausgestaltet sind, um in Reaktion auf das Auftreten eines Single-Event-Effekts in dem zweiten Schaltkreisabschnitt die Stromaufnahme des zweiten Schaltkreisabschnittes zu begrenzen. Gemäß diesem vorteilhaften Aspekt der Erfindung wird berücksichtigt, dass innerhalb eines Schaltkreises zwei oder mehr unabhängige Schaltkreisabschnitte vorliegen können, die jeweils eigene Schaltmittel aufweisen, über welche die Stromaufnahme individuell für jeden Schaltkreisabschnitt unabhängig begrenzt werden kann. Erfindungsgemäß kann nur der entsprechende betroffene Schaltkreisabschnitt von der Stromversorgung getrennt werden. Dies ermöglicht eine Unterteilung eines erfindungsgemäßen Schaltkreises in eine Mehrzahl von Schaltkreisabschnitten, welche alle individuell bezüglich des Auftretens von Single-Event-Effekten überwacht und ein- oder ausgeschaltet werden können. Hierdurch kann die Funktionsfähigkeit des erfindungsgemäßen Schaltkreises weitestmöglich gewahrt werden, auch wenn ein Teil der Schaltung, d.h. eine Komponente oder mehrere Komponenten, durch energiereiche Strahlung gestört wurde. Dieser Aspekt der Erfindung ermöglicht in vorteilhafter Weise einen Schutz vor SELs, welcher als Mikroschutz bezeichnet werden kann. Dabei wird eine Vielzahl sehr kleiner Layoutgebiete z.B. einer integrierten Schaltung und damit auch verhältnismäßig kleiner Latchupströme überwacht und ggf. abgeschaltet. Schalter bzw. Schaltmittel zum Ein- und Ausschalten der Betriebsspannung können an zahlreichen Kreuzungspunkten der Versorgungsleitungen vorgesehen sein. Eine derartige Gebietsaufteilung ermöglicht eine deutlich feinere und damit bessere Überwachung komplexer digitaler oder analoger Schaltungen auf das Auftreten unerwünschter Ereignisse wie Single Event-Effekte.

Gemäß der Erfindung erstreckt sich das vorteilhafte Aufteilen in individuell steuerbare erste und zweite Schaltkreisabschnitte auf Schaltungen, welche redundant aufgebaut sind. Bei derartigen Schaltungen sind ein oder mehrere Teile der Schaltung nicht nur einmal, sondern mehrfach vorgesehen, so dass eine geringere Anfälligkeit gegen Fehler besteht. Werden derartige redundante Schaltungsteile individuell auf das Auftreten eines Single-Event-Effekts überwacht und entsprechend strombegrenzt bzw. abgeschaltet, sobald für diesen Schaltkreisabschnitt ein solches Event auftritt, dann kann aufgrund der Redundanz der Schaltung erfindungsgemäß ein nach außen ungestörter Betrieb der Schaltung gewährleistet werden. Sobald beispielsweise ein erster Schaltkreisabschnitt in Reaktion auf einen Single Event-Effekt abgeschaltet wird, kann die bestimmungsgemäße Funktion von dem zweiten Schaltkreisabschnitt, welcher die gleichen Aufgaben erfüllt wie der erste Schaltkreisabschnitt, übernommen werden. Besonders vorteilhaft ist es, wenn die Schaltkreisabschnitte parallel arbeiten. Dann kann der Betrieb, trotz auftreten eines Ereignisses, ohne Unterbrechung fortgesetzt werden.

Gemäß einem weiteren vorteilhaften Aspekt der vorliegenden Erfindung wird zur Umsetzung der Erfindung ein Steuerungsmittel vorgesehen, welches ausgestaltet ist, um das zweite Schaltmittel zu betätigen, um in Reaktion auf das Auftreten eines Single-Event-Effekts in dem zweiten Schaltkreisabschnitt die Stromaufnahme des zweiten Schaltkreisabschnittes zu begrenzen. Eine derartige Ausgestaltung begünstigt den effektiven Aufbau und das effektive Design von Schaltkreisabschnitten, in dem jeder Schaltkreisabschnitt ein Steuerungsmittel umfasst, welches die Überwachung bzw. die Detektion von Single-Event-Effekten in einem jeweils anderen Schaltkreisabschnitt übernimmt und die Schaltmittel des jeweils anderen Schaltkreisabschnittes entsprechend betätigt. Hierzu kann vorteilhaft eine bestimmte digitale Steuerungslogik vorgesehen sein. Damit die Steuerungslogik nicht etwa selbst von dem gleichen Single Event-Effekt betroffen ist, ist es besonders vorteilhaft, wenn diese jeweils einem anderen Schaltkreisabschnitt zugeordnet ist, als demjenigen, welcher von der Steuerungslogik überwacht und ggf. abgeschaltet wird. Die Steuerungsmittel sind weiterhin vorteilhaft ausgestaltet um die Steuerung der Schaltkreisabschnitte auch für andere Zwecke, insbesondere im Hinblick auf ein effektives Power-Management vorzunehmen.

Gemäß einem weiteren vorteilhaften Aspekt der Erfindung umfasst der erfindungsgemäße Schaltkreis eine Auswahllogik, welche z.B. auch als Voter bezeichnet wird, die basierend auf einer Mehrzahl von korrespondierenden Signalen redundanter Schaltkreisabschnitte ein gültiges Auswahlsignal selektiert. Dies ermöglicht es, in vorteilhafter Weise redundante Schaltungskonzepte mit den erfindungsgemäßen Aspekten zu kombinieren. Hierdurch wird ermöglicht, dass ein erfindungsgemäßer Schaltkreis die bestimmungsgemäßen Funktionen trotz Single-Event-Effekts fortsetzen kann, ohne dass für andere Schaltungen, welche mit dem erfindungsgemäßen Schaltkreis gekoppelt sind, eine Fehlfunktion in Erscheinung tritt. Sobald jeweils ein Single-Event-Effekt in einem der ersten oder zweiten Schaltkreisabschnitte auftritt, sorgt die Auswahlschaltung dafür, dass für die weitere Signalverarbeitung ein nicht beeinträchtigtes Signal verwendet wird. Für diesen Auswahlvorgang kommen unterschiedliche Mechanismen in Betracht, welche alle die Vorteile dieses erfindungsgemäßen Aspekts nutzen. Eine derartige Auswahllogik lässt sich vorteilhaft sowohl für doppelt redundante Systeme (Double Module Redundancy = DMR) als auch für Systeme mit stärkerer Redundanz einsetzen.

Gemäß einem weiteren vorteilhaften Aspekt der vorliegenden Erfindung ist in dem erfindungsgemäßen Schaltkreis noch ein dritter Schaltkreisabschnitt mit dritten Schaltmitteln vorgesehen, welche ausgestaltet sind, um in Reaktion auf das Auftreten eines Single-Event-Effekts in dem dritten Schaltkreisabschnitt die Stromaufnahme des dritten Schaltkreisabschnittes zu begrenzen. Bei einer derartigen Ausgestaltung kann weiterhin vorteilhaft vorgesehen werden, dass der erste, zweite und dritte Schaltkreisabschnitt jeweils erste, zweite und dritte Steuerungsmittel zum Betätigen der ersten, zweiten und dritten Schaltmittel aufweisen, wobei die Steuerungsmittel derart mit den Schaltmitteln gekoppelt sind, dass jeweils die Steuerungsmittel eines Schaltkreisabschnittes die Schaltmittel eines anderen Schaltkreisabschnittes betätigen. Hierdurch ergibt sich eine vorteilhafte paarweise Überwachung und Steuerung von Schaltkreisabschnitten, so dass jeder Schaltkreisabschnitt die Steuerungsmittel zur Steuerung eines jeweils nächsten anderen Schaltkreisabschnittes aufweist. Hierdurch kann die Funktionalität der Schaltung gewährleistet werden.

Um den Betrieb der Schaltung erfindungsgemäß zu gewährleisten, weist der erfindungsgemäße Schaltkreis außerdem Synchronisationsmittel auf, welche sicherstellen, dass beim Auftreten eines Single-Event-Effektes in einem der Schaltkreisabschnitte und der darauf folgenden Strombegrenzung bzw. dem darauf folgenden Abschalten dieses Schaltkreisabschnittes der Betrieb mit der erforderlichen Synchronität bzw. mit dem erforderlichen Timing fortgesetzt werden kann. Hierzu kann es erforderlich sein, bestimmte Taktflanken für eine gewisse Zeit zu unterdrücken oder zu verzögern, um die Auswahl eines geeigneten Signals durch die Auswahlschaltung zu gewährleisten. Sobald der Auswahlvorgang abgeschlossen ist, wird dann mit dem richtigen Timing und mit der erforderlichen Synchronität der Betrieb fortgesetzt. Erfindungsgemäß sorgen die Synchronisationsmittel demnach dafür, dass diese ein digitales Taktsignal derart anpassen, dass wenn ein Fehler infolge eines Single-Event-Effekts auftritt, das digitale Taktsignal eine wirksame Ausgabe eines Signals erst indiziert, wenn der Fehler kompensiert ist.

Gemäß der vorliegenden Erfindung wird die bereits vorhandene Redundanz des elektrischen Schaltkreises ausgenutzt, indem für jeden Teil der elektrischen Schaltung, welcher aufgrund der Redundanz mehrfach ausgeführt ist, eine eigene Schaltvorrichtung vorgesehen ist, um nur diesen Bereich von der Spannungsversorgung zu entkoppeln.

Gemäß einem weiteren vorteilhaften Aspekt der Erfindung weisen das erste Detektionsmittel und das erste Schaltmittel gemeinsame elektronische Komponenten auf. Dies gelingt z.B. durch Verwendung eines Schalttransistors in einem Pfad der Versorgungsspannung, welcher als Schaltmittel verwendet wird. Tritt ein entsprechender Single-Event-Effekt auf, wird der Schalttransistor dazu verwendet, den ersten Schaltkreisabschnitt von der Spannungsversorgung zu trennen. Gleichzeitig wird der Spannungsabfall zum Detektieren eines Stromes verwendet, welcher einen bestimmten maximalen Wert überschreitet. Hierdurch werden mittels derselben Komponente ein Teil der Detektionsfunktion und eine Strombegrenzung vorgenommen.

Gemäß einem weiteren vorteilhaften Aspekt der Erfindung sind einer oder mehrere Teile der Schaltkreisabschnitte als Standardzellen ausgestaltet. Dies ermöglicht eine kompakte und einfache Anordnung von erfindungsgemäßen Schaltkreisabschnitten beim Entwurf integrierter digitaler Schaltungen. Die Anschlüsse für die erforderlichen Eingänge und Ausgänge, um die Schaltmittel zu betätigen, müssen dabei derart angeordnet sein, dass eine einfache Verdrahtung im Rahmen eines Standardzellenlayouts möglich ist.

Die Aufgabe wird ebenfalls erfindungsgemäß durch ein Verfahren zum Entwerfen eines elektronischen Schaltkreises gemäß Anspruch 13 gelöst, welches unter anderen die Schritte beinhaltet: Anordnen einer Mehrzahl redundanter Schaltkreisabschnitte, Anordnen von Schaltmitteln, welche ausgestaltet sind, die Stromaufnahme des betroffenen Schaltkreisabschnittes zu begrenzen, Anordnen von Steuerungsmitteln, welche ausgestaltet sind, um die einem jeweiligen anderen Schaltkreisabschnitt zugeordneten Schaltmittel in Reaktion auf einen Single-Event-Effekt in dem anderen Schaltkreisabschnitt dazu zu veranlassen, den Schaltkreisabschnitt von der Versorgungsspannung zu trennen.

Ein Aspekt der vorliegenden Erfindung besteht also darin, alle Schaltungsteile innerhalb einer integrierten Schaltung mit Vorrichtungen zum Ausschalten oder Einschalten der Betriebsspannung in Reaktion auf das Auftreten eines Ereignisses, wie eines SEL (Latchup), zu versehen. Dafür können Schalter verwendet werden, die als MOS-Transistoren mit niedrigem ON-Widerstand ausgestaltet sind, um Leistungsverluste möglichst gering zu halten. Ein positiver Nebeneffekt der zu diesem Zweck vorgesehenen Schalter besteht in der automatischen Strombegrenzung, wodurch die Auswirkungen eines SEL auf einen begrenzten, lokalen Bereich beschränkt werden. Das Abschalten der Versorgungsspannung mittels der Schalter beim Auftreten eines SEL muss erfindungsgemäß sehr schnell erfolgen, um die thermische Zerstörung der MOS-Transistoren zu vermeiden. Dies ermöglicht es, bereits im Hinblick auf SEUs geschützte Schaltkreise zusätzlich gegen SELs zu schützen. Insbesondere kann eine zusätzliche Schaltung vorgesehen sein, welche den redundanten Aufbau bereits vorhandener Komponenten ausnutzt. Weiter sind Schalter zum Ein- und Ausschalten der Betriebsspannung und eine korrespondierende Steuerungslogik vorzusehen. Diesbezüglich ist vor allem die einfache Realisierung einer derartigen Schaltung hervorzuheben. Eine weitere Möglichkeit besteht darin, den SEU- und SEL-Schutz bereits auf Systemebene zu kombinieren. Hierfür werden drei redundante und separat versorgte Systeme vorgesehen, welche zusätzlich je eine Auswahlschaltung (Voter) für den TMR SEU-Schutz erhalten. Hieran ist vorteilhaft, dass ein geringerer Schaltungsaufwand als bei der ersten Alternative auftritt. Wird der Schutz gegen SEL auf Systemebene und gegen SEU auf Zellebene kombiniert, ist es erfindungsgemäß möglich, ein TMR-Design über drei redundante und getrennt versorgte Systeme zu realisieren. Insbesondere ist hierdurch ein umfassender MBU-Schutz realisierbar.

Die Ausführungsbeispiele der vorliegenden Erfindung werden im Folgenden beispielhaft unter Bezugnahme auf die beigefügten Figuren erläutert. Es zeigt:
- Fig. 1: eine vereinfachte Illustration des redundanten Aufbaus einer Schaltung gemäß dem Stand der Technik,
- Fig. 2: eine vereinfachte Darstellung eines ersten Ausführungsbeispiels gemäß einem vorteilhaften Aspekt der vorliegenden Erfindung,
- Fig. 3: eine vereinfachte Darstellung eines zweiten Ausführungsbeispiels gemäß einem vorteilhaften Aspekt der vorliegenden Erfindung,
- Fig. 4: eine vereinfachte Darstellung eines dritten Ausführungsbeispiels gemäß einem vorteilhaften Aspekt der vorliegenden Erfindung,
- Fig. 5: eine vereinfachte Darstellung eines vierten Ausführungsbeispiels gemäß einem vorteilhaften Aspekt der vorliegenden Erfindung,
- Fig. 6: eine vereinfachte Darstellung eines fünften Ausführungsbeispiels gemäß einem vorteilhaften Aspekt der vorliegenden Erfindung, und
- Fig. 7: eine vereinfachte Darstellung eines sechsten Ausführungsbeispiels gemäß einem vorteilhaften Aspekt der vorliegenden Erfindung.

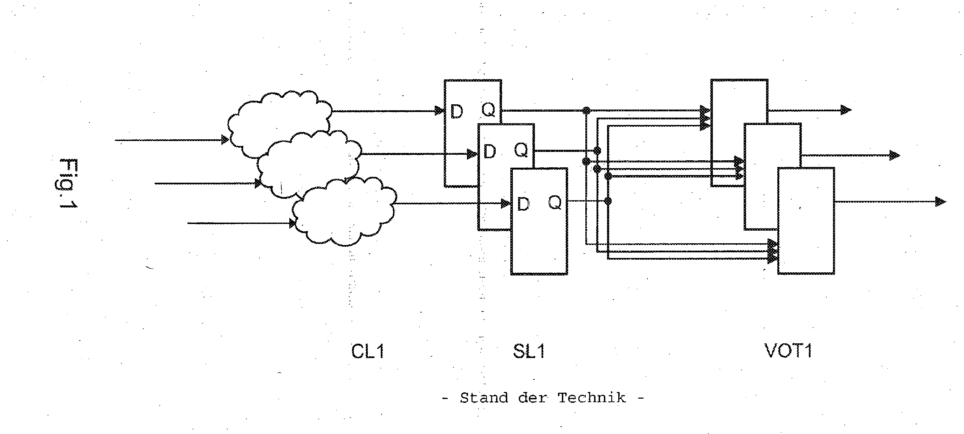

Fig. 1 zeigt eine vereinfachte Darstellung eines redundanten Schaltkreises zur Vermeidung von Single-Event-Upsets (SEU). Hierbei handelt es sich um ein TMR-Design. Die herkömmliche Schaltung umfasst eine kombinatorische Logik CL1 zur Bereitstellung der erforderlichen logischen Funktionen. Auf die kombinatorische Logik CL1 folgt die sequentielle Logik SL1. Die sequentielle Logik SL1 setzt sich im Wesentlichen aus Flipflops, z.B. D Flipflops, zusammen. Auf die sequentielle Logik SL1 folgt eine Auswahlschaltung, die als eine Gruppe von Votern VOT1 ausgestaltet ist, welche die Ausgangssignale der sequentiellen Logik SL1, d.h. der Flipflops, selektiert und für eine darauf folgende weitere Schaltung auswählt. Die kombinatorische Logik CL1 und sequentielle Logik SL1 ist redundant, d.h. dreifach, in gleicher Weise aufgebaut. Die Funktionen jedes der drei Teile sind dabei identisch. Im Normalfall sollten alle Flipflops der sequentiellen Logik SL1 das gleiche Ausgangssignal produzieren. Weicht aufgrund eines Ereignisses, wie einem SEU, ein Ausgang eines Flipflops vom richtigen Wert ab, so wird anhand der anderen Ausgänge in Form einer Mehrheitsentscheidung entschieden, welches das richtige Ausgangssignal ist. Liegen z.B. zwei Ausgänge auf logisch '1' und nur ein Ausgang auf logisch '0', so entscheiden die Voter VOT1, dass die logische '1' der richtige Wert ist. Bei einer derartigen, Anordnung ist auf Schaltungsebene kein weiterer Schutz vor anderen Ereignissen, wie z.B. SEL, vorgesehen.

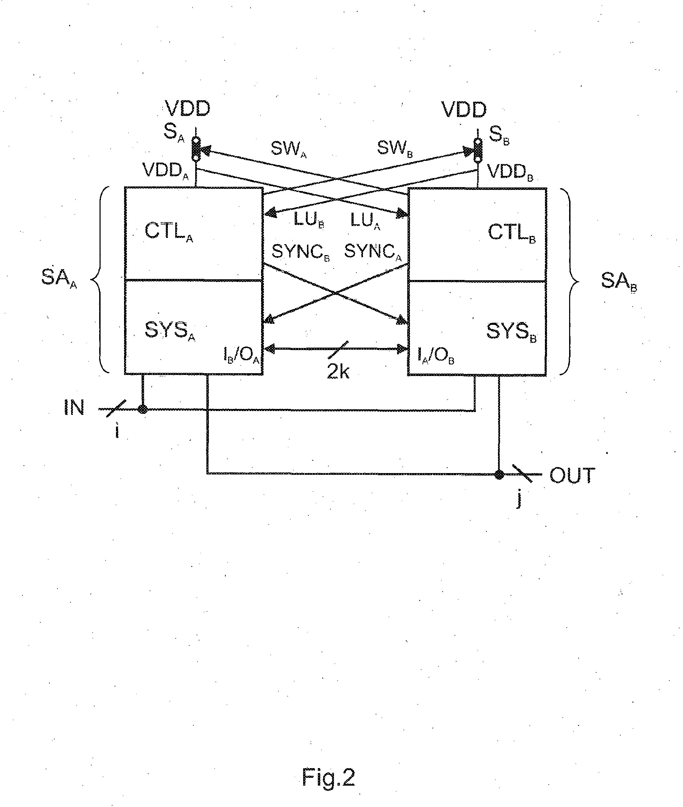

Fig. 2 zeigt eine vereinfachte Darstellung eines ersten Ausführungsbeispiels gemäß einem vorteilhaften Aspekt der vorliegenden Erfindung. Die Schaltkreisabschnitte SA_{A} und SA_{B} beinhalten jeweils die Systeme SYS_{A}, SYS_{B} und die Steuerungslogik CTL_{A} und CTL_{B}. Es sind zwei Systeme SYS_{A} und SYS_{B} vorgesehen, welche als redundante Schaltungskomponenten beide die gleiche Funktion innerhalb der Schaltung erfüllen. Wie bezüglich Fig. 1 bereits erläutert, könnte es sich hierbei um Flipflops der sequentiellen Logik, aber auch um jedwede digitale Schaltung, Logik, Speicher etc. handeln. Im Schaltkreisabschnitt SA_{A} erhält die Steuerungslogik CTL_{A} am Eingang LU_{B} ein Signal, welches von der Spannungsversorgung VDD_{B} des Schaltkreisabschnittes SA_{B} abgeleitet ist. In Reaktion auf dieses Signal wird am Ausgang SW_{B} ein Steuersignal für den Schalter S_{B} bereitgestellt, welcher den Schaltkreisabschnitt SA_{B} (die Steuerungslogik CTL_{B} und das System SYS_{B}) von der Spannungsversorgung trennen kann. Quasi spiegelbildlich hierzu erhält die Steuerungslogik CTL_{B} des Schaltkreisabschnittes SA_{B} ein entsprechendes Signal am Eingang LU_{A}, welches von der Spannungsversorgung VDD_{A} des Schaltkreisabschnittes SA_{A} abgeleitet ist. In Reaktion auf dieses Signal erzeugt die Steuerungslogik CTL_{B} am Ausgangs SW_{A} des Schaltkreisabschnittes SA_{B} ein Steuersignal für den Schalter S_{A}, welcher ausgestaltet ist, um den Schaltkreisabschnitt SA_{A} von der Spannungsversorgung VDD_{A} zu trennen. Die Steuerungslogik CTL_{A} erzeugt am Ausgang SYNC_{B} ein weiteres Steuersignal, um das System SYS_{A} mit dem System SYS_{B} zu synchronisieren. Entsprechend gelangt ein weiteres Synchronisationssignal von der Steuerungslogik CTL_{B} des Schaltkreisabschnittes SA_{B} vom Ausgang SYNC_{A} zum Eingang SYNC_{A} des Systems SYS_{A}. Eingabe- und Ausgabeleitungen der Systeme I_{B}/O_{A} bzw. I_{A}/O_{B} sind über eine Anzahl von 2k Leitungen miteinander gekoppelt, wenn k die Anzahl der gespeicherten Zustände, z.B. Flipflops, eines Systems ist. Die Eingänge IN umfassen i Leitungen, und die Ausgänge OUT j Leitungen. Tritt nun ein Fehlerereignis, wie bspw. ein SEL auf, dann wird der betroffene Schaltkreisabschnitt SA_{A} oder SA_{B} und damit eines der Systeme SYS_{A} oder SYS_{B} und die entsprechende Steuerungslogik CTL_{A} oder CTL_{B} von der Spannungsversorgung VDD_{A} bzw. VDD_{B} getrennt. Auf Basis der Fehlerbestimmung wird anschließend das richtige Signal OUT ermittelt und zur Weiterverarbeitung verwendet. Nach dem Ende des Auftretens eines Fehlerereignisses, also eines SEL o.Ä., synchronisieren sich die Systeme SYS_{A}, SYS_{B} über die Synchronisationsein- bzw. -ausgänge SYNC_{A}, SYNC_{B} sowie die Daten Ein-/Ausgänge der Flipflops I_{B}/O_{A} bzw. I_{A}/O_{B}. Der Vorteil dieser Anordnung besteht darin, dass das System sich trotz eines SEL wie ein störungsfreies System nach außen verhalten kann. Die in Fig. 2 dargestellte Ausgestaltung ist besonders günstig für Systemkomponenten mit begrenzter Komplexität (bezogen auf den bereits im System integrierten SEU-Schutz).

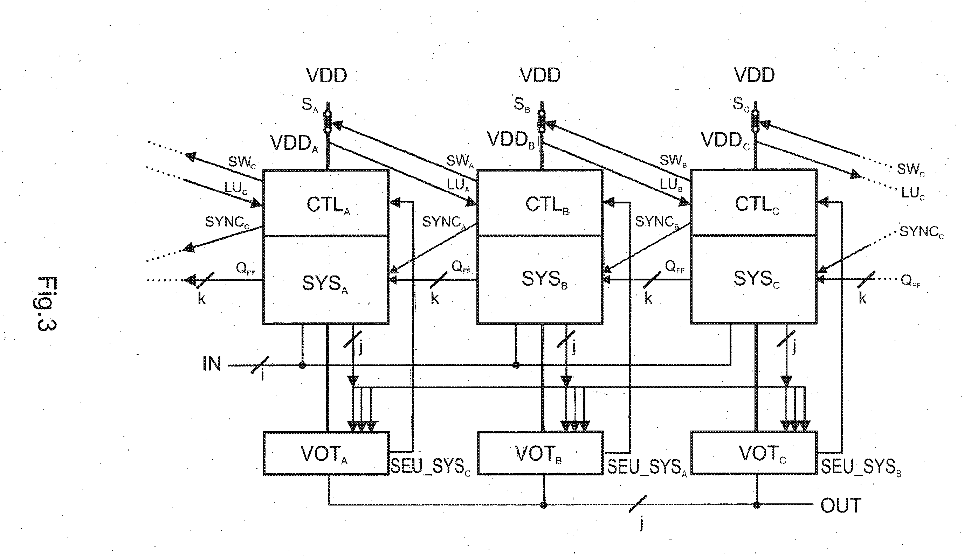

Fig. 3 zeigt eine vereinfachte Darstellung eines weiteren Ausführungsbeispiels der vorliegenden Erfindung. Hierbei sind nun drei Schaltkreisabschnitte SA_{A}, SA_{B}, SA_{C} vorgesehen. Diese beinhalten die Systeme SYS_{A}, SYS_{B}, SYS_{C}, welche gemäß der Erfindung ausgestaltet sind. Jedes der Systeme SYS_{A}, SYS_{B}, SYS_{C} wird an die Spannungsversorgung VDD angeschlossen. Aufgrund der Schalter S_{A}, S_{B}, Sc ergibt sich nach einem Schalter eine jeweilige Spannungsversorgung VDD_{A}, VDD_{B}, VDD_{C} für jeden Schaltkreisabschnitt, so dass jeder Schaltkreisabschnitt individuell abschaltbar ist. Der jeweilige Schalter S_{A}, S_{B;} S_{C} dient dazu, das System von der Spannungsversorgung zu trennen. Die Signale LU_{A}, LU_{B}, LU_{C} geben an, ob ein SEL oder ein anderes Ereignis eingetreten ist, bzw. signalisieren die Strom- bzw. Leistungsaufnahme eines entsprechenden Schaltkreisabschnittes SA_{A}, SA_{B}, SA_{C}. In Reaktion auf die Signale LU_{A}, LU_{B}, LU_{C} gibt die jeweilige Steuerungslogik CTL_{A}, CTL_{B}, CTL_{C} des jeweils angesprochenen Schaltkreisabschnittes SA_{A}, SA_{B}, SA_{C} ein Signal SW_{A}, SW_{B}, SW_{C} an den jeweiligen Schalter S_{A}, S_{B}, S_{C} aus, um den betroffenen Schaltkreisabschnitt von der Spannungsversorgung zu trennen. Beim Auftreten eines SEL in einem der drei Schaltkreisabschnitte SA_{A}, SA_{B}, SA_{C} kann demnach das entsprechende zugehörige System SYS_{A}, SYS_{B}, SYS_{C} von einem nicht betroffenen System bzw. dessen Steuerungslogik CTL_{A}, CTL_{B}, CTL_{C} von der Spannungsversorgung getrennt werden. Die Ausgangssignale der Systeme SYS_{A}, SYS_{B}, SYS_{C} werden in den Votern VOT_{A}, VOT_{B}, VOT_{C} überprüft. Die Signale SEU_SYS_{A}, SEU_SYS_{B},

SEU_SYS_{C} zeigen der jeweiligen Steuerungslogik CTL_{A}, CTL_{B}, CTL_{C} eines anderen Systems an, dass dieses seinen Nachbarn synchronisieren soll, ohne jedoch einen der Schalter S_{A}, S_{B}, S_{C} zu betätigen. Die Voter VOT_{A}, VOT_{B}, VOT_{C} nehmen eine Auswahl vor, die typischerweise basierend auf einer Mehrheitsentscheidung erfolgt. Dabei wird festgestellt, ob ein Ausgangssignal bzw. die Ausgangssignale eines Systems SYS_{A}, SYS_{B} oder SYS_{C} von den anderen beiden Systemen abweicht. Ist dies der Fall, wird das abweichende System als fehlerhaft betrachtet und mit den Ausgangssignalen der anderen beiden Systeme in Übereinstimmung gebracht. Also handelt es sich auch hierbei um ein redundantes System. Die dreifache Redundanz (TMR) ermöglicht es, dass mittels der Voter und über eine Mehrheitsentscheidung eine Feststellung getroffen werden kann, welches der Systeme fehlerhaft gearbeitet hat. Zur Synchronisation werden die Signale SYNC_{A}, SYNC_{B}, SYNC_{C} ausgegeben, und ebenso werden die Ausgangssignale OUT_{A}, OUT_{B} und OUT_{C} der drei Systeme den jeweils anderen Systemen übermittelt, so dass eine Anpassung der Ausgangssignale innerhalb der Systeme SYS_{A}, SYS_{B}, SYS_{C} erfolgen kann. Auf diese Art und Weise ist ein Schutz gegen SEUs außerhalb der einzelnen Systeme möglich, was den Schaltungsaufwand und damit die erforderliche Chipfläche reduziert. Nach außen treten einzelne Fehler nicht in Erscheinung, es besteht jedoch kein vollständiger Schutz gegen MBUs.

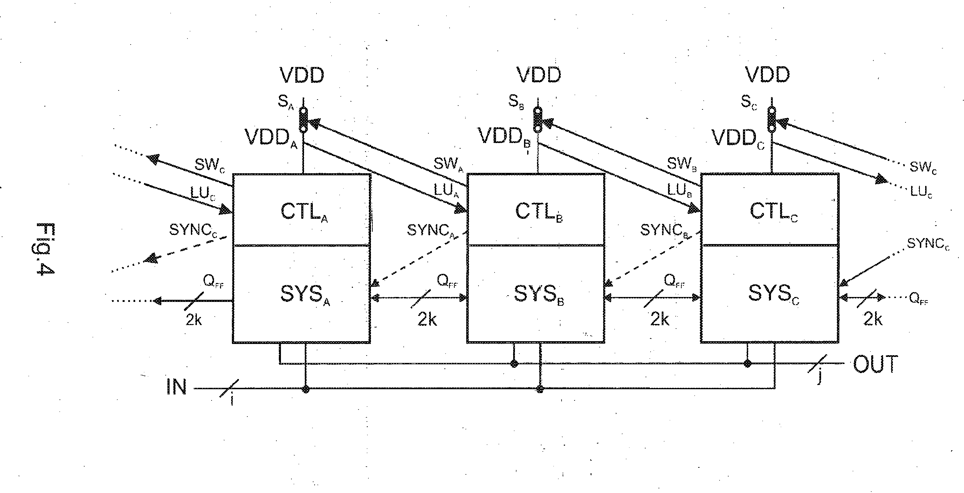

Fig. 4 zeigt eine vereinfachte Darstellung eines weiteren Ausführungsbeispiels der vorliegenden Erfindung. Die grundsätzliche Funktion stimmt mit der bezüglich Fig. 3 beschriebenen Funktion einer dreifach redundanten Ausführungsform der vorliegenden Erfindung überein. Demnach sind auch hier drei Systeme SYS_{A}, SYS_{B}, SYS_{C} vorgesehen, welche jeweils über Schalter S_{A}, S_{B}, S_{C} mit der Spannungsversorgung VDD_{A}, VDD_{B}, VDD_{C} gekoppelt sind, um im Fehlerfall das jeweilige betroffene System von der Spannungsversorgung zu trennen. Im Unterschied zum Ausführungsbeispiel gemäß Fig. 3 befinden sich die Voter nun integriert im jeweiligen System SYS_{A}, SYS_{B}, SYS_{C}. Dadurch steigt der Verdrahtungsaufwand, da z.B. jedes Flip-Flop eines Systems mit einem Voter versehen werden muss, dessen Eingänge mit allen 3 Systemen verbunden sind (vorher gab es nur einen Voter für 3 Ausgangssignale). Dafür wird jedoch voller MBU-Schutz erreicht und die Synchronisierung kann entfallen. Gleichzeitig wird erfindungsgemäß sowohl eine Realisierung der Voter VOT_{A}, VOT_{B}, VOT_{C} (aus Fig. 3) als zusätzliche Komponenten zu bereits existierenden Systemen SYS_{A}, SYS_{B}, SYS_{C}, sowie eine Realisierung als kompakte, komplette Schaltungssysteme SYS_{A}, SYS_{B}, SYS_{C} mit integrierten Votern bzw. Auswahlschaltungen vorgesehen ist. Die vereinfachte Darstellung gibt nicht alle erforderlichen Verbindungen wieder. Die SEUs werden gemäß dieser Anordnung vorteilhaft im folgenden Taktzyklus beseitigt und das Gesamtsystem ist daher nicht MBU-empfindlich. Nach außen treten die Fehler nicht in Erscheinung.

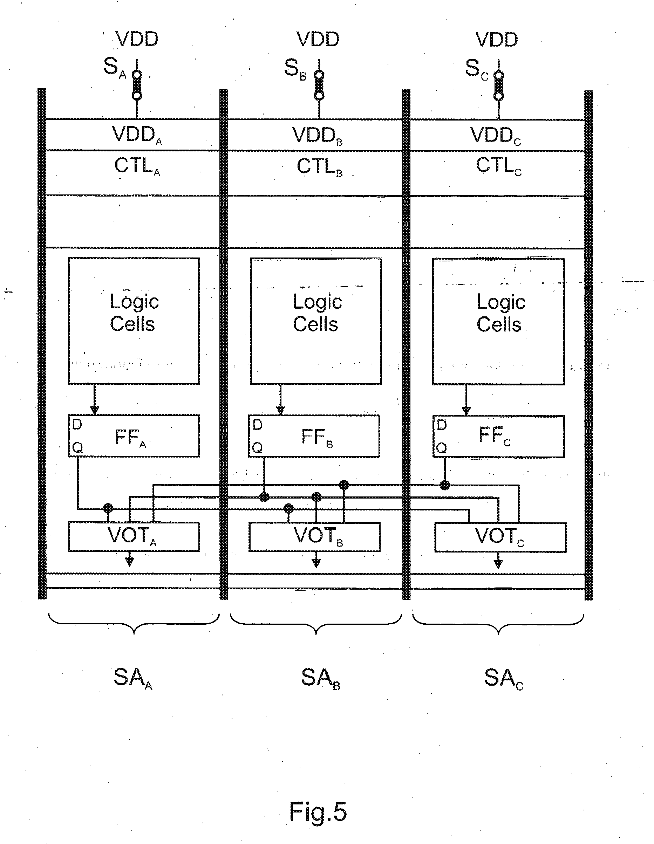

Fig. 5 zeigt eine vereinfachte Darstellung eines möglichen Layouts der Systeme. Gemäß dieser Ausgestaltung lassen sich die erfindungsgemäßen Schalkreisabschnitte SA_{A}, SA_{B} und SA_{C} vorteilhaft im Standardzellendesign realisieren. Das jeweilige System SYS_{A}, SYS_{B}, SYS_{C} ist wiederum über die Schalter S_{A}, S_{B}, Sc an die Versorgungsspannung gekoppelt. Vorteilhaft befinden sich im oberen Bereich, also der Spannungsversorgung VDD_{A}, VDD_{B}, VDD_{C}, zugeordnet die Steuerungslogikeinheiten CTL_{A}, CTL_{B}, CTL_{C}. Die Ansteuerung der Schalter S_{A}, S_{B}, S_{C} ist hier nicht dargestellt, erfolgt jedoch genauso wie bezüglich der vorangegangenen Figuren erläutert. Im mittleren Bereich befinden sich die logischen Zellen (Logic Cells), welche die Funktion bzw. die entsprechende Logik zur Umsetzung der Funktionen, die das System realisieren soll, beinhalten. Weiter sind die FlipFlops FF_{A}, FF_{B}, FF_{C} vorgesehen, welche grundsätzlich genauso agieren wie anhand der Systeme bezüglich Figuren 3 und 4 beschrieben. Die Voter sind hier als einzelne Blöcke VOT_{A}, VOT_{B}, VOT_{C} dargestellt. Diese nehmen die Auswahl der entsprechenden Ausgangssignale vor und entscheiden, welcher der Schaltkreisabschnitte SA_{A}, SA_{B}, SA_{C} einen Fehler verursacht hat und daher über die nicht von einem SEL oder ähnlichen Ereignis betroffenen Systeme synchronisiert werden muss. Bei der in Fig. 5 dargestellten Anordnung der einzelnen Komponenten bzw. der erforderlichen Blöcke kann der Verdrahtungsaufwand in sehr vorteilhafter Weise minimiert werden.

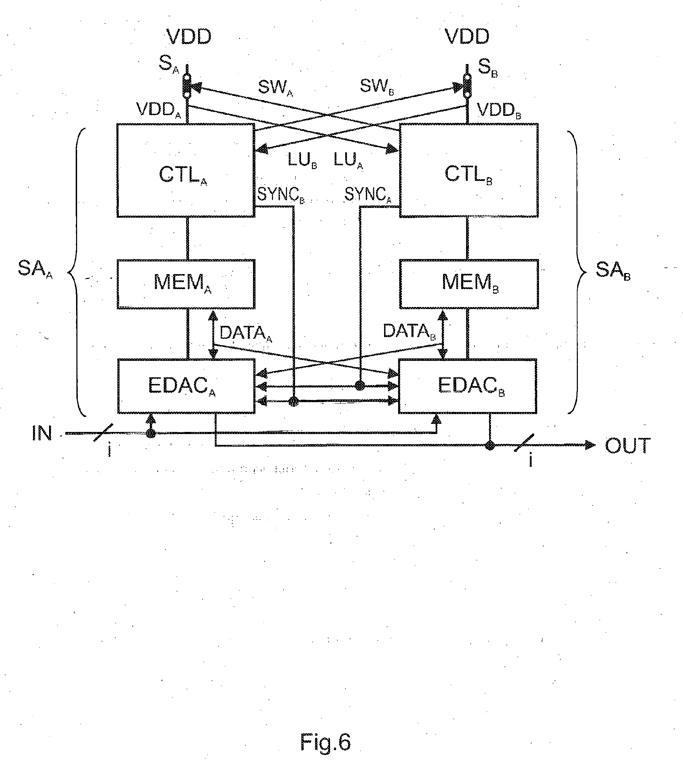

Fig. 6 zeigt eine vereinfachte Darstellung eines Ausführungsbeispiels der vorliegenden Erfindung für Speicher. Die Schaltkreisabschnitte SA_{A} und SA_{B} beinhalten Speicher MEM_{A} und MEM_{B}, Fehlerdetektions- und Korrekturblöcke EDAC_{A} und EDAC_{B} und SEL-Steuerungslogik CTL_{A} für den Schaltkreisabschnitt SA_{B} und eine SEL-Steuerungslogik CTL_{B} für den Schaltkreisabschnitt SA_{A}. Bei derartigen Speichern handelt es sich bevorzugt um integrierte Halbleiterspeicher. Die Steuerungslogik CTL_{A} und die Steuerungslogik CTL_{B} überwachen in der zuvor beschriebenen Weise die Spannungsversorgung VDD_{A} bzw. VDD_{B}. Die Schalter S_{A} bzw. S_{B} werden betätigt, wenn im jeweilig anderen Schaltkreisabschnitt ein Fehler mittels der Signale LU_{A} bzw. LU_{B} detektiert wird. Die Synchronisationsaufforderung erfolgt über die Signale SYNC_{A} bzw. SYNC_{B}, welche an die zusätzlichen Blöcke EDAC_{A} und EDAC_{B} ausgegeben werden. Die EDAC-Blöcke detektieren und korrigieren zunächst alle Fehler, die z.B. durch SEU auftreten. Dies wird z.B. durch zusätzliche Pärity-Bits bzw. Hamming-Codes ermöglicht. Falls ein SEL aufgetreten ist, wird das anschließend, d.h. nach dem Wiedereinschalten der Betriebsspannung über die Signale SYNC_{A} bzw. SYNC_{B} mitgeteilt und beide EDAC-Blöcke EDAC_{A} und EDAC_{B} übernehmen dann die Synchronisierung. Der nicht SEL-betroffene EDAC-Controller liest sämtliche Daten aus seinem Speicher und leitet sie direkt dem anderen SEL-Controller zu. Der schreibt parallel alle Daten in seinen zu synchronisierenden Speicher. Gleichzeitig werden natürlich auch eventuelle, z.B. durch SEU entstandene, Bitfehler z.B. durch die oben genannten Hamming-Codes erkannt und korrigiert. Diese Kontrolle bzw. Korrektur wird im normalen Betrieb (d.h. ohne aufgetretenen SEL) ergänzt durch den Vergleich der Daten DATA_{A}, DATA_{B} der beiden redundanten Speicher MEM_{A}, MEM_{B}. Dieser Vergleich hat Vorteile, wenn ein EDAC-Controller z.B. wegen MBU nicht mehr in der Lage ist einen Fehler zu korrigieren. In einem solchen Fall kann der richtige Wert vom jeweils anderen Speicher übernommen werden.

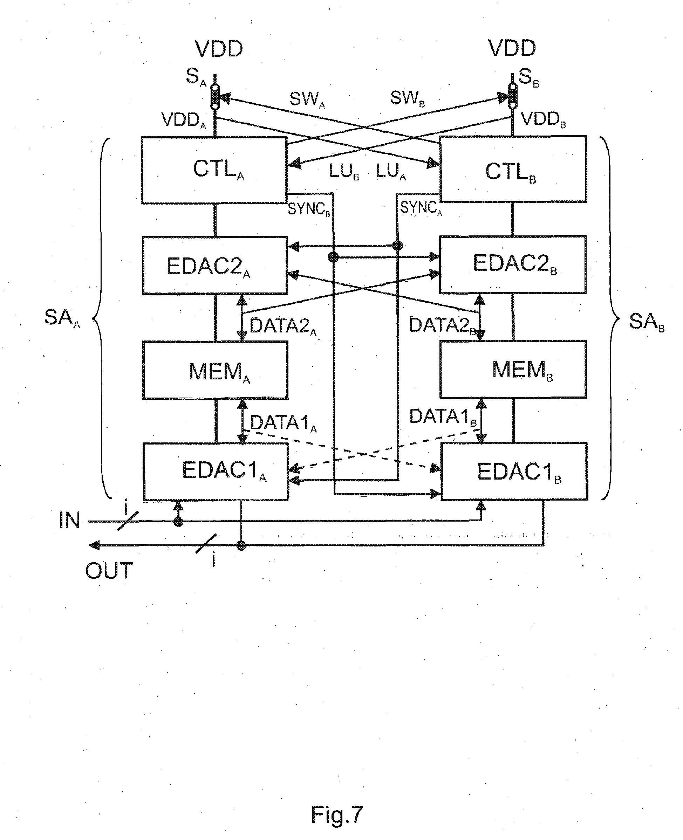

Fig. 7 zeigt eine vereinfachte Darstellung eines weiteren Ausführungsbeispiels der vorliegenden Erfindung, welches im Unterschied zum vorangegangenen Ausführungsbeispiel für Speicher auch Echtzeitanwendungen ermöglicht. Auch bei diesem Ausführungsbeispiel sind Speichervorrichtungen MEM_{A}, MEM_{B} mit einer Fehlerdetektions- und Korrekturlogik EDAC1_{A} bzw. EDAC1_{B} und EDAC2_{A} bzw. EDAC2_{B} und Steuerungslogik CTL_{A}, CTL_{B} ausgestattet. Die Schaltkreisabschnitte SA_{A} und SA_{B} sind mittels der Schalter S_{A} und S_{B} von der Spannungsversorgung in Reaktion auf das Auftreten eines Ereignisses, wie einem SEL, trennbar. Die Schaltkreisabschnitte SA_{A} und SA_{B} umfassen Steuerungslogik CTL_{A} und CTL_{B}, sowie Speicher MEM_{A} und MEM_{B}. Die grundsätzlichen Abläufe bezüglich der Signale LU_{A}, LU_{B} und SYNC_{A} bzw. SYNC_{B} auf die Schalter S_{A}, S_{B} erfolgt wie bereits erläutert. In dem hier dargestellten Beispiel sind die Speicherkomponenten MEM_{A} und MEM_{B} als Dual Port Memories ausgeführt. Die Synchronisierung der Speicherkomponenten MEM_{A} und MEM_{B} wird dadurch von externen Zugriffen unabhängig. Außerdem ist es möglich, in einem sogenannten Refresh im Hintergrund MBUs zu vermeiden. Bei einem derartigen Refresh wird der gesamte Speicher zyklisch ausgelesen und eventuelle Fehler werden sofort korrigiert. Diese Art des Refresh ist von dem Speicher-Refresh bei dynamischen Speichern zu unterscheiden, die ohne Refresh ihre in Kondensatoren gespeicherten Daten verlieren würden. Die Schreib- und Lesezugriffe auf die Speicherkomponenten können parallel erfolgen. Hierdurch wird eine Reduzierung der Synchronisationszeiten möglich. Außerdem besteht die Möglichkeit, dass die Fehler nach außen völlig unbemerkt bleiben. Tritt nun ein Fehler auf, können die Daten der Speicher intern synchronisiert werden, ohne dass diese nach außen hin auftauchen. Hierzu sind zwei Datenbusse DATA2_{A} und DATA2_{B} vorgesehen. Außerdem sind gegenüber dem Ausführungsbeispiel auf Fig. 6 zusätzliche Korrekturblöcke EDAC2_{A} und EDAC2_{B} vorgesehen, welche eine interne Synchronisation ermöglichen. Der Austausch der Daten von dem jeweilig nicht betroffenen Speicherbaustein MEM_{A} bzw. MEM_{B} zu dem betroffenen Baustein MEM_{B} bzw. MEM_{A} kann nun intern über die Datenbusse DATA2_{A}, und DATA2_{B} erfolgen, ohne dass die Synchronisierung nach außen hin in Erscheinung tritt. Die Zeiten für die Synchronisierung und den Refresh sind unabhängig von der Frequenz der externen Speicherzugriffe über die Datenbusse DATA1_{A} und DATA1_{B}. Ein zusätzlicher Schutz vor Fehlerereignissen wie MBUs kann durch Vergleich der Daten beider Speicher erreicht werden.

Eines der zentralen Probleme nach dem Auftreten und der Detektion eines SEL und dem Wiedereinschalten der Betriebsspannung ist die möglichst schnelle Synchronisierung der betroffenen Baugruppen (d.h. Schaltkreisabschnitte), um den Schutz des Gesamtsystems vor weiteren SELs oder auch SEUs wieder herzustellen. Vorteilhaft und angestrebt ist eine Behandlung der Fehler, welche nach außen nicht in Erscheinung tritt. Vorstellbar sind demnach auch eine parallele Synchronisierung, eine serielle Synchronisierung und weitere spezielle Synchronisierungsmechanismen für Speicher und Register. Bei der parallelen Synchronisierung entsprechend der ernsten zwei Ausführungsbeispiele erfolgt die Synchronisierung der gestörten Komponenten asynchron über den Set/Reset-Eingang der Flipflops direkt nach einer Datenübernahme von der ungestörten Seite. Generell ist damit ein höherer Verdrahtungsaufwand zwischen den Flipflops der redundanten Schaltkreisabschnitte erforderlich. Bei einer etwas verminderten, aber konstanten Taktfrequenz kann vermieden werden, dass die Fehler nach außen hin in Erscheinung treten. Diesbezüglich ist vorteilhaft eine Verzögerungszeit für die Synchronisation zu berücksichtigen. Wird eine höhere Taktfrequenz gewünscht, kann z.B. eine Taktperiode des Systemtäkts während der Synchronisation ausgelassen werden. Bei der seriellen Synchronisation kann z.B. eine für Testzwecke bereits vorhandene Scan-Chain eingesetzt werden. Dabei ist die Verzögerung abhängig von der Anzahl der Komponenten, wie z.B. der Flipflops. Das System kann während dieser Synchronisation nicht weiterarbeiten. Eine zusätzliche Implementierung von Schieberegistern ermöglicht, dass das System weiterarbeiten kann und Fehler nach außen hin nicht in Erscheinung treten. Neben der speziellen Synchronisation für Speicher- und Registerbänke sind die Speicherbaugruppen mit SEU-Schutzbits (z.B. Parity) und zugehörige Auswerte-/Steuerlogik versehen. Außerdem kann die Steuerlogik für einen vorstehend beschriebenen Refresh im Hintergrund eingesetzt werden, um MBUs zu vermeiden. Dabei wird der gesamte Speicher zyklisch ausgelesen, und eventuelle Fehler werden sofort korrigiert.

Zur Reduzierung des Verdrahtungsaufwands kann die Anordnung im Layout angepasst werden. Es werden immer abwechselnd die redundanten und getrennt versorgten Zellen in jeweils drei nebeneinander liegende Spalten angeordnet. An jedem Kreuzungspunkt der Versorgungsleitungen können die benötigten Schalter (Schaltmittel) und die Detektionsmittel (z.B. Komparatoren) angeordnet werden. Auf diese Art und Weise kann auch ungenutzte Chipfläche vorteilhaft verwendet werden. Der restliche Teil der erforderlichen Steuerung kann sowohl dezentral als auch zentral an einer Stelle für alle erforderlichen Steuerungsaufgaben angeordnet sein. Es bietet sich an, basierend auf den vorteilhaften Aspekten der vorliegenden Erfindung eigene Standardzellen zu entwerfen, welche z.B. Flipflops mit Votern oder Makrozellen für jeweils drei redundante und getrennt versorgte Standardzellen beinhalten.

Die erfindungsgemäßen Schaltmittel, also Transistoren etc. lassen sich darüber hinaus bei allen vorstehenden Ausführungsbeispielen nicht nur für SELs einsetzen, sondern können generell für ein verbessertes Power-Management verwendet werden.

Bei einer weiteren vorteilhaften Ausgestaltung der vorliegenden Erfindung werden viele Schalter zum Schutz vor Mikro-SELs eingesetzt. Die Schalter sind dann vorzugsweise sehr klein auszuführen. Beim Einsatz vieler solcher kleinen Schalter kann bei einem SEL die durch den eingeschalteten Schalter hervorgerufene Strombegrenzung unter dem Thyristor- Haltestrom liegen. In einer solchen Situation ist ein aufwändiges SEL-Management überflüssig, denn während des SEL sorgen die Voter für das richtige Ausgangssignal und nach dem SEL ist der Kurzschluss automatisch behoben. Demnach können also die Schaltkreisabschnitte und die zugehörigen Schalter so ausgestaltet sein, dass ein SEL in einem Schaltkreisabschnitt einen Strom zur Folge hat, welcher unter dem Thyristor-Haltestrom liegt, so dass es nicht zu einer dauernden Stromerhöhung kommt.

Bei einer anderen vorteilhaften Ausgestaltung der vorstehenden Ausführungsbeispiele können die Controller und Voter so umgeschaltet werden, dass auch eine separate Nutzung der redundanten Systeme - also z.B. ohne SEU/SEL Schutz möglich ist. Außerdem kann die Logik vorsehen, dass redundante Systeme abgeschaltet werden, wenn die Systeme (also ein erfindungsgemäßer elektronischer Schaltkreis mit entsprechenden Schaltkreisabschnitten) in einer strahlensicheren Umgebung eingesetzt werden. Dadurch kann vorteilhaft Strom eingespart werden.

## Patentansprüche

1. Elektrischer Schaltkreis mit einem ersten Schaltkreisabschnitt (SA_{A}) und einem zweiten Schaltkreisabschnitt (SA_{B}), die derart ausgestaltet sind, dass die Schaltkreisabschnitte In redundanter Weise eine gleiche Funktion ausüben, wobei der elektrische Schaltkreisumfasst:
- erste Schaltmittel (S_{A}), welche ausgestaltet sind, um in Reaktion auf das Auftreten eines Single-Event-Effekts in dem ersten Schaltkreisabschnitt (SA_{A}) die Stromaufnahme des ersten Schaltkreisabschnittes (SA_{A}) zu begrenzen;
- zweite Schaltmittel (S_{B}), welche ausgestaltet sind, um in Reaktion auf das Auftreten eines Single-Event-Effekts in dem zweiten Schaltkreisabschnitt (SA_{B}) die Stromaufnahme des zweiten Schaltkreisabschnittes (SA_{B}) zu begrenzen; **gekennzeichnet durch**
- Synchronisationsmittel (SYNC, EDAC_{A}, EDAC_{B}) zum Synchronisieren der Schaltkreisabschnitte, wobei die Synchronisationsmittel ausgebildet sind, nach dem Ende des Auftretens des Single-Event-Effektes eine Übernahme von Daten durch gestörte Komponenten des vom Single-Event-Effekt betroffenen der Schaltkreisabschnitte vom anderen der Schaltkreisabschnitte zu bewirken.

2. Elektrischer Schaltkreis nach Anspruch 1, **dadurch gekennzeichnet, dass** der erste Schaltkreisabschnitt (SA_{A}) Steuerungsmittel (CTL_{A}) umfasst, welche ausgestaltet sind, die zweiten Schaltmittel (S_{B}) zu betätigen, um in Reaktion auf das Auftreten des Single-Event-Effekts in dem zweiten Schaltkreisabschnitt (SA_{B}) die Stromaufnahme des zweiten Schaltkreisabschnittes (SA_{B}) zu begrenzen.

3. Elektrischer Schaltkreis nach einem der vorstehenden Ansprüche, **gekennzeichnet durch** dem ersten Schaltkreisabschnitt (SA_{A}) zugeordnete erste Detektionsmittel zum Detektieren eines Ereignisses, insbesondere eines Stromes, der auf dem Single Event-Effekt beruht.

4. Elektrischer Schaltkreis nach einem der vorstehenden Ansprüche, **dadurch gekennzeichnet, dass** eine Auswahlschaltung (VOT_{A}, VOT_{B}) vorgesehen ist, welche aus einer Mehrzahl von korrespondierenden Signalen der Schaltkreisabschnitte (SA_{A}, SA_{B}) ein gültiges Signal selektiert.

5. Elektrischer Schaltkreis nach einem der vorstehenden Ansprüche, **gekennzeichnet durch** einen dritten Schaltkreisabschnitt (SA_{C}) mit dritten Schaltmitteln welche ausgestaltet sind, um in Reaktion auf das Auftreten eines Single Event-Effekts in dem dritten Schaltkreisabschnitt (SA_{C}) die Stromaufnahme des dritten Schaltkreisabschnittes (SA_{C}) zu begrenzen.

6. Elektrischer Schaltkreis nach Anspruch 5, **dadurch gekennzeichnet, dass** der erste, zweite und dritte Schaltkreisabschnitt (SA_{A}, SA_{B}, SA_{C}) jeweils erste, zweite, und dritte Steuerungsmittel (CTL_{A}, CTL_{B}, CTL_{C}) zum Betätigen der ersten, zweiten und dritten Schaltmittel aufweisen, wobei die Steuerungsmittel (CTL_{A}, CTL_{B}, CTL_{C}) derart mit den Schaltmitteln (S_{A}, S_{B}, S_{C}) gekoppelt sind, dass jeweils die Steuerungsmittel (CTL_{A}, CTL_{B}, CTL_{C}) eines Schaltkreisabschnittes die Schaltmittel (S_{A}, S_{B}, S_{C}) eines anderen Schaltkreisabschnittes (SA_{A}, SA_{B}, SA_{C}) betätigen.

7. Elektrischer Schaltkreis nach einem der vorstehenden Ansprüche, **dadurch gekennzeichnet, dass** die Detektionsmittel und die Schaltmittel (S_{A}, S_{B}, S_{C}) gemeinsame elektronische Komponenten umfassen.

8. Elektrischer Schaltkreis nach einem der vorstehenden Ansprüche, **dadurch gekennzeichnet, dass** die Synchronisationsmittel derart ausgestaltet sind, dass diese ein digitales Taktsignal derart anpassen, dass wenn ein Fehler infolge eines Single-Event-Effektes auftritt, das digitale Taktsignal eine wirksame Ausgabe eines Signals erst indiziert, wenn der Fehler kompensiert ist.

9. Elektrischer Schaltkreis nach einem der Ansprüche 5 bis 8, **dadurch gekennzeichnet, dass** die Auswahlschaltung (VOT_{A}, VOT_{B}, VOT_{C}) ausgestaltet ist, um basierend auf einer Mehrzahl von korrespondierenden Signalen redundanter Schaltkreisabschnitte ein Auswahlsignal zu definieren, welches geeignet ist, mit seinem Wert den richtigen Wert eines Signals eines von einem Single-Event-Effekt betroffenen Schaltkreisabschnittes der redundanten Schaltkreisabschnitte zu repräsentieren.

10. Elektrischer Schaltkreis nach Anspruch 9, **dadurch gekennzeichnet, dass** die Auswahlschaltung ausgestaltet ist, um die Auswahl basierend auf einer Mehrheitsentscheidung vorzunehmen, so dass das Auswahlsignal derart definiert wird, dass es den gleichen Wert aufweist, wie die Mehrzahl der korrespondierenden Signale.

11. Elektrischer Schaltkreis nach einem der vorstehenden Ansprüche, **dadurch gekennzeichnet, dass** Teile eines Schaltkreisabschnittes (SA_{A}, SA_{B}, SA_{C}) als Standardzellen ausgestaltet sind.

12. Elektrischer Schaltkreis nach einem der vorstehenden Ansprüche, **dadurch gekennzeichnet, dass** ein Schaltkreisabschnitt (SA_{A}, SA_{B}) einen Speicher (MEM_{A}, MEM_{B}) umfasst.

13. Verfahren zum Entwerfen eines elektrischen Schaltkreises, mit den Schritten:
- Anordnen einer Mehrzahl redundanter Schaltkreisabschnitte (SAA, SAB, SAC),
- Anordnen von Schaltmitteln (SA, SB, SC), welche ausgestaltet sind, die Stromaufnahme des betroffenen Schaltkreisabschnittes (SAA, SAB, SAC) zu begrenzen,
- Anordnen von Steuerungsmitteln (CTLA, CTLB, CTLC) welche ausgestaltet sind,
- die einem jeweiligen anderen Schaltkreisabschnitt (SAA, SAB, SAC) zugeordneten Schaltmittel (SA, SB, SC) in Reaktion auf einen Single-Event-Effekt in dem anderen Schaltkreisabschnitt (SAA, SAB, SAC) dazu zu veranlassen, den Schaltkreisabschnitt (SAA, SAB, SAC) von der Versorgungsspannung zu trennen; **dadurch gekennzeichnet, dass** die Steuerungsmittel zusätzlich ausgestaltet werden,
- eine Synchronisierung der Schaltkreisabschnitte (SA_{A}, SA_{B}, SA_{C}) derart vorzunehmen, dass nach dem Ende des Auftretens des Single-Event-Effektes eine Übernahme von Daten durch gestörte Komponenten des vom Single-Event-Effekt betroffenen der Schaltkreisabschnitte vom anderen der Schaltkreisabschnitte erfolgt.

14. Verfahren nach Anspruch 13 mit dem weiteren Schritt: Anordnen einer Auswahlschaltung (VOT_{A}, VOT_{B}, VOT_{C}), welche ausgestaltet ist, um basierend auf einer Mehrzahl von korrespondierenden Signalen redundanter Schaltkreisabschnitte (SA_{A}, SA_{B}, SA_{C}) ein Auswahlsignal zu definieren, welches geeignet ist, mit seinem Wert den richtigen Wert eines Signals eines von einem Single Event-Effekt betroffenen Schaltkreisabschnittes der redundanten Schaltkreisabschnitte zu repräsentieren.

## Claims

1. Electrical circuit having a first circuit portion (SA_{A}) and a second circuit portion (SA_{B}) which are configured such that the circuit portions redundantly perform the same function, the electrical circuit comprising:
- first switching means (S_{A}) which are configured so as to limit the current consumption of the first circuit portion (SA_{A}) in response to the occurrence of a single event effect in the first circuit portion (SA_{A});
- second switching means (S_{B}) which are configured so as to limit the current consumption of the second circuit portion (SA_{B}) in response to the occurrence of a single event effect in the second circuit portion (SA_{B}); **characterised by**
- synchronising means (SYNC, EDAC_{A}, EDAC_{B}) for synchronising the circuit portions, the synchronising means being configured to carry out a transfer of data by disrupted components of the one of the circuit portions affected by the single event effect from the other of the circuit portions, after the end of the occurrence of the single event effect.

2. Electrical circuit according to claim 1, **characterised in that** the first circuit portion (SA_{A}) comprises control means (CTL_{A}) which are configured to actuate the second switching means (S_{B}), so as to limit the current consumption of the second circuit portion (SA_{B}) in response to the occurrence of the single event effect in the second circuit portion (SA_{B}).

3. Electrical circuit according to one of the preceding claims, **characterised by** first detection means associated with the first circuit portion (SA_{A}) for detecting an event, particularly a current, that is based on the single event effect.

4. Electrical circuit according to one of the preceding claims, **characterised in that** a selection circuit (VOT_{A}, VOT_{B}) is provided which selects a valid signal from a plurality of corresponding signals of the circuit portions (SA_{A}, SA_{B}).

5. Electrical circuit according to one of the preceding claims, **characterised by** a third circuit portion (SA_{C}) with third switching means, which are configured to limit the current consumption of the third circuit portion (SA_{C}) in response to the occurrence of a single event effect in the third circuit portion (SA_{C}).

6. Electrical circuit according to claim 5, **characterised in that** the first, second and third circuit portions (SA_{A}, SA_{B}, SA_{C}) respectively comprise first, second and third control means (CTL_{A}, CTL_{B}, CTL_{C}) for actuating the first, second and third switching means, the control means (CTL_{A}, CTL_{B}, CTL_{C}) being coupled to the switching means (S_{A}, S_{B}, S_{C}) such that the control means (CTL_{A}, CTL_{B}, CTL_{C}) of one circuit portion actuate the switching means (S_{A}, S_{B}, S_{C}) of another circuit portion (SA_{A}, SA_{B}, SA_{C}).

7. Electrical circuit according to one of the preceding claims, **characterised in that** the detecting means and the switching means (S_{A}, S_{B}, S_{C}) comprise common electronic components.

8. Electrical circuit according to one of the preceding claims, **characterised in that** the synchronising means are configured so as to adapt a digital clock signal in such a way that if an error occurs as a result of a single event effect, the digital clock signal only indicates an effective emission of a signal once the error has been compensated.

9. Electrical circuit according to one of claims 5 to 8, **characterised in that** the selection circuit (VOT_{A}, VOT_{B}, VOT_{C}) is configured to define a selection signal, based on a plurality of corresponding signals from redundant circuit portions, which, with its value, is suitable for representing the correct value of a signal of a circuit portion of the redundant circuit portions that is affected by a single event effect.

10. Electrical circuit according to claim 9, **characterised in that** the selection circuit is configured to carry out the selection on the basis of a majority decision, so that the selection signal is defined such that it has the same value as the majority of the corresponding signals.

11. Electrical circuit according to one of the preceding claims, **characterised in that** parts of a circuit portion (SA_{A}, SA_{B}, SA_{C}) are configured as standard cells.

12. Electrical circuit according to one of the preceding claims, **characterised in that** a circuit portion (SA_{A}, SA_{B}) comprises a memory (MEM_{A}, MEM_{B}).

13. Method of designing an electrical circuit, comprising the steps of:
- arranging a plurality of redundant circuit portions (SAA, SAB, SAC),
- arranging switching means (SA, SB, SC) which are configured so as to limit the current consumption of the relevant circuit portion (SAA, SAB, SAC),
- arranging control means (CTLA, CTLB, CTLC) which are configured
- to cause the switching means (SA, SB, SC) associated with another respective circuit portion (SAA, SAB, SAC), to separate the circuit portion (SAA, SAB, SAC) from the supply voltage in response to a single event effect in the other circuit portion (SAA, SAB, SAC); **characterised in that** the control means are additionally configured to:
- carry out synchronisation of the circuit portions (SA_{A}, SA_{B}, SA_{C}) such that, after the end of the occurrence of the single event effect, a transfer of data is carried out by disrupted components of the one of the circuit portions affected by the single event effect from the other of the circuit portions.

14. Method according to claim 13, comprising the further step of: arranging a selection circuit (VOT_{A}, VOT_{B} VOT_{C}) which is configured to define a selection signal, based on a majority of corresponding signals from redundant circuit portions (SA_{A}, SA_{B}, SA_{C}), which, with its value, is suitable for representing the correct value of a signal of one circuit portion of the redundant circuit portions that is affected by a single event effect.

## Revendications

1. Circuit électrique avec une première section de circuit (SA_{A}) et une deuxième section de circuit (SA_{B}) qui sont conçues de façon à ce que les sections de circuit remplissent une même fonction de manière redondante, le circuit électrique comprenant :
- des premiers moyens de commutation (SA) conçus pour limiter la consommation de courant de la première section de circuit (SA_{A}) en réaction à l'apparition d'un événement singulier dans la première section de circuit (SA_{A}) ;
- des deuxièmes moyens de commutation (S_{B}) conçus pour limiter la consommation de courant de la deuxième section de circuit (SA_{B}) en réaction à l'apparition d'un événement singulier dans la deuxième section de circuit (SA_{B}) ; **caractérisé en ce que**
- des moyens de synchronisation (SYNC, EDAC_{A}, EDAC_{B}) pour synchroniser les sections de circuit, les moyens de synchronisation étant conçus, après la fin de l'apparition de l'événement singulier, pour provoquer une prise en charge des données par des composants défectueux de la section de circuit touchée par l'événement singulier par l'autre section de circuit.

2. Circuit électrique selon la revendication 1, **caractérisé en ce que** la première section de circuit (SA_{A}) comprend des moyens de commande (CTL_{A}) conçus pour actionner les deuxièmes moyens de commutation (S_{B}) afin de limiter la consommation de courant de la deuxième section de circuit (SA_{B}) en réaction à l'apparition d'un événement singulier dans la deuxième section de circuit (SA_{B}).

3. Circuit électrique selon l'une des revendications précédentes, **caractérisé par** des premiers moyens de détection correspondant à la première section de circuit (SA_{A}) pour la détection d'un événement, plus particulièrement d'un courant provoqué par un événement singulier.

4. Circuit électrique selon l'une des revendications précédentes, **caractérisé en ce qu'**un circuit de sélection (VOTA, VOT_{B}) est prévu, qui sélectionne un signal valide parmi une pluralité de signaux correspondants des sections de circuit (SA_{A}, SA_{B}).

5. Circuit électrique selon l'une des revendications précédentes, **caractérisé par** une troisième section de circuit (SA_{C}) avec des troisièmes moyens de commutation conçus pour limiter la consommation de la troisième section de circuit (SA_{C}) en réaction à l'apparition d'un événement singulier dans la troisième section de circuit (SA_{C}).

6. Circuit électrique selon la revendication 5, **caractérisé en ce que** la première, la deuxième et la troisième section de circuit (SA_{A}, SA_{B}, SA_{C}) comprennent chacune respectivement des premiers, des deuxièmes et des troisièmes moyens de commande (CTL_{A}, CTL_{B}, CTL_{C}) pour l'actionnement des premiers, deuxièmes et troisièmes moyens de commutation, les moyens de commande (CTL_{A}, CTL_{B}, CTL_{C}) étant couplés aux moyens de commutation (SA, S_{B}, S_{C}) de façon à ce que les moyens de commande (CTL_{A}, CTL_{B}, CTL_{C}) d'une section de circuit actionnent les moyens de commutation (SA, S_{B}, S_{C}) d'une autre section de circuit (SA_{A}, SA_{B}, SA_{C}).

7. Circuit électrique selon l'une des revendications précédentes, **caractérisé en ce que** les moyens de détection et les moyens de commutation (SA, S_{B}, S_{C}) comprennent des composants électroniques communs.

8. Circuit électrique selon l'une des revendications précédentes, **caractérisé en ce que** les moyens de synchronisation sont conçus de façon ce qu'ils adaptent un signal d'horloge numérique de façon à ce que, lorsqu'une erreur survient du fait d'un événement singulier, le signal d'horloge numérique ne produit une sortie de signal valide que lorsque l'erreur est compensée.

9. Circuit électrique selon l'une des revendications 5 à 8, **caractérisé en ce que** le circuit de sélection (VOT_{A}, VOT_{B}, VOT_{C}) est conçu pour définir, sur la base d'une pluralité de signaux correspondants de sections de circuit redondantes, un signal de sélection destiné à représenter, avec sa valeur, la valeur correcte d'un signal d'une section de circuit des sections de circuit redondantes, affectée par un événement singulier.

10. Circuit électrique selon la revendication 9, **caractérisé en ce que** le circuit de sélection est conçu pour effectuer la sélection sur la base d'une décision à la majorité, de façon à ce que le signal de sélection soit défini de telle sorte que qu'il présente la même valeur que la plupart des signaux correspondants.

11. Circuit électrique selon l'une des revendications précédentes, **caractérisé en ce que** des parties d'une section de circuit (SA_{A}, SA_{B}, SA_{C}) sont conçues comme des cellules standard.

12. Circuit électrique selon l'une des revendications précédentes, **caractérisé en ce qu'**une section de circuit (SA_{A}, SA_{B}) comprend une mémoire (MEM_{A}, MEM_{B}).

13. Procédé de conception d'un circuit électrique comprenant les étapes suivantes :
- disposition d'une pluralité de sections de circuit redondantes (SA_{A}, SA_{B}, SA_{C}),
- disposition de moyens de commutation (SA, S_{B}, S_{C}) conçus pour limiter la consommation de courant de la section de circuit (SA_{A}, SA_{B}, SA_{C}) affectée,
- disposition de moyens de commande (CTL_{A}, CTL_{B}, CTL_{C}) conçus
- pour faire en sorte qu'un moyen de commutation (SA, S_{B}, S_{C}) d'une autre section de circuit (SA_{A}, SA_{B}, SA_{C}), en réaction à un événement singulier dans l'autre section de circuit (SA_{A}, SA_{B}, SA_{C}), déconnecte la section de circuit (SA_{A}, SA_{B}, SA_{C}) de la tension d'alimentation ; **caractérisé en ce que** les moyens de commande sont en outre conçus
- pour effectuer une synchronisation des sections de circuit (SA_{A}, SA_{B}, SA_{C}) de telle sorte que, après la fin de l'apparition de l'événement singulier, une prise en charge des données par des composants perturbés de la section de circuit affectée par l'événement singulier soit effectuée par une autre section de circuit.

14. Procédé selon la revendication 13 avec l'étape supplémentaire suivante : disposition d'un circuit de sélection (VOT_{A}, VOT_{B}, VOT_{C}) conçu pour définir, sur la base d'une pluralité de signaux correspondants de sections de circuit redondantes (SA_{A}, SA_{B}, SA_{C}), un signal de sélection destiné à représenter, avec sa valeur, la valeur correcte d'un signal d'une section de circuit des sections de circuit redondantes, affectée par un événement singulier.
